Europäisches Patentamt

European Patent Office

Office européen des brevets

(11) Veröffentlichungsnummer: **0 499 061 A1**

## (12) EUROPÄISCHE PATENTANMELDUNG

(21) Anmeldenummer: **92100991.6**

(22) Anmeldetag: **22.01.92**

(51) Int. Cl.5: **H03K 5/13**

(30) Priorität: **13.02.91 DE 4104269**

(43) Veröffentlichungstag der Anmeldung:
**19.08.92 Patentblatt 92/34**

(84) Benannte Vertragsstaaten:
**AT BE CH DE ES FR GB IT LI NL SE**

(71) Anmelder: **Standard Elektrik Lorenz Aktiengesellschaft Lorenzstrasse 10 W-7000 Stuttgart 40(DE)**

(72) Erfinder: **Kopp, Dieter Hirschstrasse 34 W-7254 Hemmingen(DE)**

(74) Vertreter: **Pohl, Herbert, Dipl.-Ing et al Standard Elektrik Lorenz AG Patent- und Lizenzwesen Postfach 30 09 29 W-7000 Stuttgart 30(DE)**

(54) **Verzögerungsschaltung sowie Verfahren zur Verzögerung eines Binärsignals.**

(57) Die Erfindung betrifft eine Verzögerungsschaltung mit einstellbarer Verzögerungszeit für die Ausgabe eines aus mindestens einem Bit bestehenden Binärsignals. Sie zeichnet sich durch ein als FIFO (first-in, first-out) ausgebildetes Schieberegister (2) aus, in das in Abhängigkeit der gewünschten Verzögerungszeit Initialisierungsdaten eingeschrieben werden. Ferner wird ein Verfahren zur Verzögerung eines Binärsignals angegeben.

FIG.1

EP 0 499 061 A1

Die Erfindung betrifft eine Verzögerungsschaltung mit einstellbarer Verzögerungszeit für die Ausgabe eines aus mindestens einem Bit bestehenden Binärsignals.

In der Elektrotechnik, insbesondere in der Digitaltechnik, ist es zur Lösung verschiedener Problemstellungen oftmals erforderlich, ein Datensignal nicht unmittelbar, sondern verzögert zu übertragen.

Es ist bekannt, einen Ringspeicher im Arbeitsspeicher eines Mikro-Prozessors zu verwenden, in den ein zu verzögerndes Binärsignal eingeschrieben und dann -zur gewünschten Zeit- ausgelesen wird. Dies erfordert jedoch einen relativ hohen Softwareaufwand für den Einschreib- und Auslesezeiger. Ferner muß eine Ringspeicherendabfrage vorgesehen sein. Insgesamt liegt eine hohe Rechenzeitbelastung des Mikro-Prozessors vor.

Der Erfindung liegt daher die Aufgabe zugrunde, eine Verzögerungsschaltung der eingangs genannten Art zu schaffen, mit der mit einfachen Mitteln die Verzögerung eines aus mindestens einem Bit bestehenden Binärsignals möglich ist.

Diese Aufgabe wird erfindungsgemäß gelöst durch ein als FIFO (first-in, first-out) ausgebildetes Schieberegister, in das in Abhängigkeit der gewünschten Verzögerungszeit Daten eingeschrieben werden, von denen eine eingeschriebene Initialisierungsdatenfolge die Verzögerungszeit und eine eingeschriebene Nutzdatenfolge eine Information darstellt. Erfindungsgemäß wird also nicht nur ein eine Information darstellende Binärsignal in das FIFO eingeschrieben, sondern eine bestimmt ausgebildete Initialisierungsdatenfolge, deren Länge die Verzögerungszeit definiert. Beim Auslesen der Bits werden zuerst die Initialisierungsdaten und im Anschluß die Nutzdaten ausgegeben. Zur Initialisierung der Zeitverzögerung werden -entsprechend der gewünschten Verzögerungszeit- zum Beispiel N Initalisierungsdaten eingeschrieben. Bei einem Datentransfer wird nun ein Binärsignal in das FIFO eingeschrieben und ein um N Bit verzögertes Binärsignal ausgelesen. Durch die Variation der Wahl der Zahl N läßt sich die Verzögerungszeit -wie bereits erwähnt- frei einstellen.

Nach einer Weiterbildung der Erfindung ist vorgesehen, daß das FIFO einen Write- und einen Read-Eingang aufweist, daß der Read-Eingang an eine Datentransfer-Befehlsleitung angeschlossen ist, die zu dem Eingang eines Oder-Glieds führt und daß eine Initialisierungsleitung an einen weiteren Eingang des Oder-Glieds angeschlossen ist, dessen Ausgang mit dem Write-Eingang des FIFO's in Verbindung steht.

Die erfindungsgemäße Verzögerungsschaltung kann auch mit Hilfe eines Mikro-Prozessors realisiert werden. Hierzu ist vorgesehen, daß der Mikro-Prozessor mit einem Datenbus-Ausgang versehen ist, der an das FIFO angeschlossen ist und daß der Mikro-Prozessor einen Write-Ausgang aufweist, der mit einem Write-Eingang des FIFO's verbunden ist. Ferner ist eine Datenanforderungs-Befehlsleitung vorgesehen, die an einen Read-Eingang des FIFO's und an einen Steuereingang des Mikro-Prozessors zum Einschreiben der Nutzdatenfolgen des Datenbusses in das FIFO angeschlossen ist. Die Initialisierungsdaten werden bei Programmstart vom Mikro-Prozessor in das FIFO eingeschrieben.

Die Erfindung betrifft ferner ein Verfahren zur Verzögerung eines aus mindestens einem Bit bestehenden Binärsignals, wobei in Abhängigkeit der gewünschten Verzögerungszeit Daten in ein als FIFO (first-in, first-out) ausgebildetes Schieberegister eingeschrieben werden, von denen eine eingeschriebene Initialisierungsdatenfolge die Verzögerungszeit und eine eingeschriebene Nutzdatenfolge eine Information darstellt.

Die Zeichnung veranschaulicht die Erfindung anhand zweier Ausführungsbeispiele und zwar zeigt:

Figur 1    ein Blockschaltbild einer erfindungsgemäße Verzögerungsschaltung und

Figur 2    ein weiteres Blockschaltbild einer Verzögerungsschaltung mit Mikro-Prozessor.

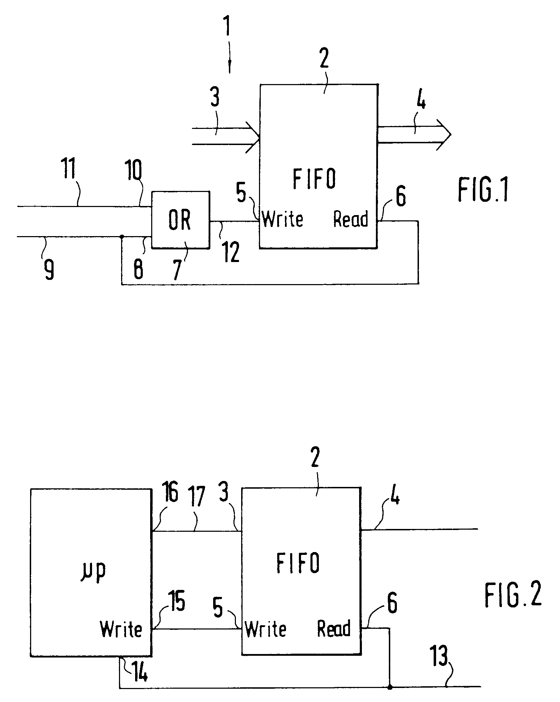

Die Figur 1 zeigt eine Verzögerungsschaltung 1 in Form eines Blockschaltbilds. Diese weist ein als FIFO (first-in, first-out) ausgebildetes Schieberegister 2 auf. Das FIFO 2 besitzt einen Dateneingang 3 und einen Datenausgang 4. Ferner weist das FIFO 2 einen Write-Eingang 5 und einen Read-Eingang 6 auf.

Die Figur 1 zeigt ferner ein Oder-Glied 7. Das Oder-Glied 7 weist einen Eingang 8 auf, an den eine Datentransfer-Befehlsleitung 9 angeschlossen ist. Ferner ist das Oder-Glied 7 mit einem weiteren Eingang 10 versehen, an den eine Initialisierungsleitung 11 angeschlossen ist. Der Ausgang 12 des Oder-Glieds 7 ist an den Write-Eingang 5 des FIFO's 2 angeschlossen. Die Datentransfer-Befehlsleitung 9 führt nicht nur zum Eingang 8 des Oder-Glieds 7, sondern auch zum Read-Eingang 6 des FIFO's 2.

Das Ausführungsbeispiel der Figur 1 arbeitet folgendermaßen:

Liegt auf der Initialisierungsleitung 11 ein Signal an, so wird der Write-Eingang 5 des FIFO's 2 angesteuert und es wird dadurch eine Initialisierungsdatenfolge in das FIFO 2 eingeschrieben. Diese Initialisierungsdatenfolge entspricht einer Verzögerungszeit, wobei die Länge der Initialisierungsdatenfolge die Dauer der Verzögerungszeit bestimmt.

Wird die Datentransfer-Befehlsleitung 9 mit einem Signal beaufschlagt, so wird über das Oder-Glied 7 der Write-Eingang 5 und auf direktem Wege der Read-Eingang 6 des FIFO's 2 angesteuert. Dies hat zur Folge, daß einerseits ein zuvor eingeschriebenes Binärsignal als Nutzdatenfolge am Datenausgang 4 ausgegeben wird. Diese Ausgabe erfolgt mit der zugehörigen entsprechenden Verzögerungszeit. Ferner wird ein neues Nutzdatensignal über den Dateneingang 3 in das FIFO eingegeben werden.

Im Ausführungsbeispiel der Figur 2 ist dem FIFO 2 ein Mikro-Prozessor µP zugeordnet. Es ist eine Datenanforderungs-Befehlsleitung 13 vorgesehen, die zu einem Steuereingang 14 des Mikro-Prozessors µP führt. Gleichzeitig ist die Datenanforderungs-Befehlsleitung 13 an den Read-Eingang 6 des FIFO's 2 angeschlossen. Der Write-Eingang 5 des FIFO's 2 steht mit einem Write-Ausgang 15 des Mikro-Prozessors µP in Verbindung. Ein Ausgang 16 des Mikro-Prozessors führt zu einem Datenbus 17, der an den Dateneingang 3 des FIFO's 2 angeschlossen ist. Ferner weist das FIFO 2 den Datenausgang 4 auf.

Die Schaltung der Figur 2 arbeitet folgendermaßen:
Wird mittels der Datenanforderungs-Befehlsleitung 13 sowohl der Steuereingang 14 des Mikro-Prozessors µP, als auch der Read-Eingang 6 des FIFO's 2 angesteuert, so wird das FIFO 2 veranlaßt, ein Binärsignal an seinem Datenausgang 4 auszugeben, was mit einer gewünschten Verzögerungszeit erfolgt. Diese Verzögerungszeit ist dadurch einstellbar, daß der Mikro-Prozessor µP über seinen Ausgang 16 und den Datenbus 17 Daten in das FIFO einschreibt, wobei es sich dabei um eine Initialisierungsdatenfolge handelt, die die Verzögerungszeit definiert.

**Patentansprüche**

1. Verzögerungsschaltung mit einstellbarer Verzögerungszeit für die Ausgabe eines aus mindestens einem Bit bestehenden Binärsignals, **gekennzeichnet durch** ein als FIFO (first-in, first-out) ausgebildetes Schieberegister (2), in das in Abhängigkeit der gewünschten Verzögerungszeit Daten eingeschrieben werden, von denen eine eingeschriebene Initialisierungsdatenfolge die Verzögerungszeit und eine eingeschriebene Nutzdatenfolge eine Information darstellt.

2. Verzögerungsschaltung nach Anspruch 1, **dadurch gekennzeichnet,** daß das FIFO (2) einen Write- und einen Read-Eingang (5,6) aufweist, daß der Read-Eingang (6) an eine Datentransfer-Befehlsleitung (9) angeschlossen ist, die zu dem Eingang (8) eines Oder-Glieds (7) führt und daS eine Initialisierungsleitung (11) an einen weiteren Eingang (10) des Oder-Glieds (7) angeschlossen ist, dessen Ausgang (12) mit dem Write-Eingang (5) des FIFO's (2) in Verbindung steht.

3. Verzögerungsschaltung nach Anspruch 1, **gekennzeichnet durch** einen Mikro-Prozessor (µP) mit einem Datenbus-Ausgang (Ausgang 16), der an das FIFO (2) angeschlossen ist und mit einem Write-Ausgang (15), der mit einem Write-Eingang (5) des FIFO's (2) verbunden ist sowie mit einer Datenanforderungs-Befehlsleitung (13), die an einen Read-Eingang (6) des FIFO's (2) und an einen Steuereingang (14) des Mikro-Prozessors (µP) zum Einschreiben der Initialisierungsdaten und Nutzdaten des Datenbusses (17) in das FIFO (2) angeschlossen ist.

4. Verfahren zur Verzögerung eines aus mindestens einem Bit bestehenden Binärsignals, **dadurch gekennzeichnet,** daß in Abhängigkeit der gewünschten Verzögerungszeit Daten in ein als FIFO (first-in, first-out) ausgebildetes Schieberegister (2) eingeschrieben werden, von denen eine eingeschriebene Initialisierungsdatenfolge die Verzögerungszeit und eine eingeschriebene Nutzdatenfolge eine Information darstellt.

FIG.1

FIG.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN vol. 13, no. 198 (E-756)11. Mai 1989 & JP-A-1 019 822 ( NEC CORP ) 23. Januar 1989 | 1-2 | H03K5/13 |
| A | | 3-4 | |
| X | PATENT ABSTRACTS OF JAPAN vol. 12, no. 357 (E-662)26. September 1988 & JP-A-63 114 411 ( NEC CORP ) 19. Mai 1988 | 1-2 | |
| A | * Zusammenfassung * | 3-4 | |
| A | PATENT ABSTRACTS OF JAPAN vol. 12, no. 395 (E-671)20. Oktober 1988 & JP-A-63 136 814 ( NEC CORP ) 9. Juni 1988 * Zusammenfassung * | 1-4 | |
| A | PATENT ABSTRACTS OF JAPAN vol. 10, no. 251 (E-432)28. August 1986 & JP-A-61 080 911 ( NEC CORP ) 24. April 1986 * Zusammenfassung * | 1-4 | |
| A | PATENT ABSTRACTS OF JAPAN vol. 8, no. 202 (P-300)14. September 1984 & JP-A-59 085 971 ( MITSUBISHI DENKI K.K. ) 18. Mai 1984 * Zusammenfassung * | | RECHERCHIERTE SACHGEBIETE (Int. Cl.5) H03K G06F |
| A | US-A-4 443 765 (FINDEISEN ET AL.) | | |
| A | WO-A-8 802 955 (DEUTSCHE THOMSON-BRANDT GMBH) | | |

Der vorliegende Recherchenbericht wurde für alle Patentansprüche erstellt

| Recherchenort | Abschlußdatum der Recherche | Prüfer |
|---|---|---|
| DEN HAAG | 21 MAI 1992 | SEGAERT P.A.O.M.P. |